# EUROPÄISCHE PATENTSCHRIFT

(11) **EP 0 763 854 B1**
(45) Veröffentlichungstag und Bekanntmachung des Hinweises auf die Patenterteilung: **19.01.2000**
(21) Anmeldenummer: 96112662.0
(22) Anmeldetag: 06.08.1996
(51) Int. Cl.: H01L 27/08, H01L 27/06, H01L 21/8252

(54) **Schaltkreis mit monolithisch integrierter PIN-/Schottky-Diodenanordnung**
Circuit with monolithic integrated arrangement of PIN/Schottky diodes
Circuit comprenant un arrangement intégré monolithique de diodes PIN/Schottky

(30) Priorität: 18.09.1995 DE 19530525
(43) Veröffentlichungstag der Anmeldung: 19.03.1997
(73) Patentinhaber: DaimlerChrysler AG, 70567 Stuttgart (DE)
(72) Erfinder: Dickmann, Jürgen, Dr.-Ing., 89073 Ulm (DE)
(74) Vertreter: Fröhling, Werner Otto, Dr.

(56) Entgegenhaltungen:
- EP-A- 0 508 128
- US-A- 4 640 003
- US-A- 4 982 269
- US-A- 5 272 370

## Beschreibung

Die Erfindung betrifft einen Schaltkreis und ein Verfahren zur Herstellung eines Schaltkreises nach den Oberbegriffen der Patentansprüche 1 und 8.

Die Erfindung findet u.a. Verwendung bei integrierten Millimeterwellen-Schaltungen zur Erzeugung und zum Empfang von Signalen in Radar- oder Kommunikationgssystemen. Derartige Front-ends enthalten u.a. Oszillatoren, Verstärker, Mischer, Frequenzverdoppler und Schalter. Mischerfunktionen können von Schottky-Dioden und Schalterfunktionen können von PIN-Dioden realisiert werden. Aus Veröffentlichungen von Charles M. Howell in Mikrowellen und Optoelektronik (MIOP/89) und A. Klassen und H. E. Sasse in Proc. Internat. Workshop of the Germen IEEE joint MTT/AP Chapter: "Silicon Base High Frequency Devices and Circuits" Vol. 10-11, 1994, P. 19, ist der Einsatz von PIN-Dioden als Schalter bekannt. Dabei können als Halbleitermaterialien sowohl Si als auch III/V-Halbleiterverbindungen verwendet werden. GaAs-Schottky-Dioden haben für Arbeitsfrequenzen bis weit in den Submillimeterwellenbereich sehr gute Mischereieigenschaften für Raumtemperaturanwendungen (D.G. Garfield et al.: "RF-performance of a Novel Planar Millimeter-Wave Diode Incorporating an Etched surface Channel", IEEE Transaction on Microwave Theory and Techniques 39 (1) 1991, S. 1-5). Die Verwendung von Schottky-Dioden als Mischer für Millimeterwellen Front-ends, wobei die Millimeterwellenschaltkreise mit der GaAs MESFET Technologie hergestellt werden, ist in einer Veröffentlichung von B. Adelseck et al in Proc. Military Microwave 1952, P. 209-214 angegeben. Diese Technologie erlaubt die monolithische Integration von Schottky-Diode und MESFET. Dadurch ist es möglich verschiedene Funktionen auf einem Chip unterzubringen.
Aus der US 5, 272,370 ist eine monolithische Integration von PIN und Schottky-Diode bekannt, wobei eine auf dem Substrat aufgebrachte Metallschicht als Kontakt und Ätzstopschicht verwendet wird. In der US 4,982,269 ist ein integrierter Millimeterwellenschaltkreis mit PIN-und Schottky-Diode beschrieben, die planar und in Mesabauweise angeordnet sind.

Aufgabe der Erfindung ist es, einen hohen Integrationsgrad von in Front-ends erforderlichen Schalter- und Mischerfunktionen auf einem Chip zu erzielen und damit eine Reduzierung der Herstellungskosten zu erreichen. Diese Aufgabe wird gelöst durch die im kennzeichnenden Teil der Patentansprüche 1 und 8 angegebenen Merkmale. Vorteilhafte Ausgestaltungen und/oder Weiterbildungen sind den Unteransprüchen zu entnehmen.

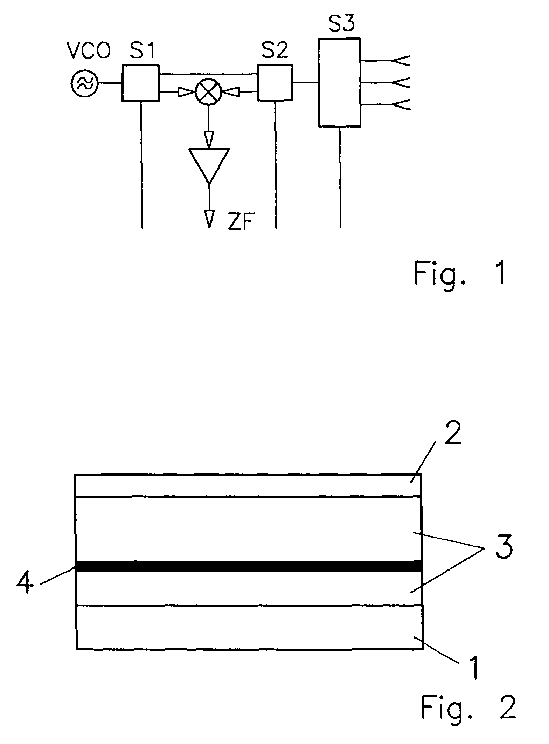

Die Erfindung hat den Vorteil, daß unterschiedliche Bauelemente wie PIN- und Schottky-Dioden auf einem Chip monolithisch integriert werden und damit Schalter- und Mischerfunktionen realisiert werden können. Dadurch ist z.B. die Herstellung eines Radar- oder Kommunikationsmoduls in wenigen Produktionsschritten möglich. FIG. 1 zeigt z.B. die prinzipielle Schaltungsstruktur eines Radarmoduls. Mit der vorliegenden Erfindung ist es beispielsweise möglich, die Schalter S₁, S₂ und den Mischer auf einen Chip monolithisch zu integrieren. Die Schalterschaltkreise können sog. "Single Pole Double Through" (SPDT) sein, für die eine oder mehrere PIN-Dioden erforderlich sind. Für den Mischer werden Schottky-Dioden verwendet.

Weiterhin ist von Vorteil, daß PIN- und Schottky-Diode in Mesabauweise angeordnet sind, da durch das vertikal zu den Halbleiterschichten verlaufende elektrische Feld schnellere Schaltzeiten erzielt werden.

Die Erfindung wird im folgenden anhand von Ausführungsbeispielen näher erläutert unter Bezugnahme auf schematische Zeichnungen.
- FIG. 2: zeigt die Schichtenfolge aus der PIN- und Schottky-Diode hergestellt werden
- FIG. 3 und 4: zeigen die Anordnung und Kontaktstrukturierung einer PIN- und Schottky-Diode.

Gemäß FIG. 2 besteht die Schichtenfolge aus einer n- und p-Kontaktschicht 1, 2 und einer zwischen den Kontaktschichten angeordneten Isolierschicht 3. Die Isolierschicht 3 enthält eine im Abstand d von der n-Kontaktschicht 1 angeordnete Ätzstopschicht 4. Der Abstand d der Ätzstopschicht von der n-Kontaktschicht 1 ist in Abhängigkeit von der Dotierkonzentration der Isolierschicht 3 derart zu wählen, daß kleine Serienwiderstände und Sperrschichtkapazitäten für die Schottky-Diode erzielt werden.

Beispielsweise wird auf ein InP-Substrat eine n-Kontaktschicht 1 aus InGaAs, eine Isolierschicht 3 aus InGaAs und in die Isolierschicht 3 eine Ätzstopschicht 4 aus InAlAs, sowie eine p-Kontaktschicht 2 aus InGaAs aufgewachsen. Eine andere Möglichkeit besteht darin, Substrat und die Schichten 1, 3, 2 aus GaAs herzustellen und die Schicht 4 aus GaInP. Die n-Kontaktschicht 1 besitzt z.B. eine Schichtdicke von weniger als 1µm und eine Dotierkonzentration N_{D} von mehr als 10¹⁸cm⁻³; die p-Kontaktschicht 2 ist etwa 100nm dick und weist eine Dotierkonzentration N_{A} von mehr als 10¹⁹cm⁻³ auf; die Isolierschicht 3 besitzt eine Schichtdicke von weniger als 2µm und eine Dotierkonzentration N_{D} kleiner als 10¹⁷cm⁻³. Die Ätzstopschicht 4 hat eine Schichtdicke von 2 bis 5nm und ist in einem Abstand d von weniger als 100nm von der n-Kontaktschicht 1 angeordnet.

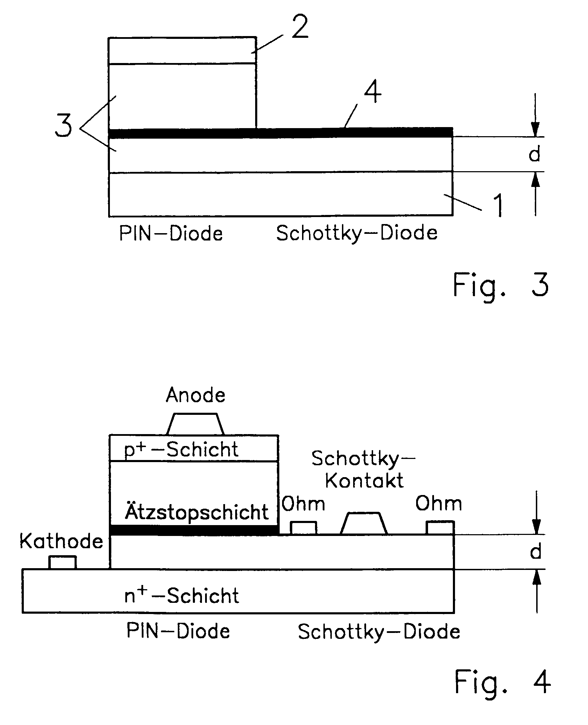

Zur Herstellung von Schottky- und PIN-Diode werden im Bereich der Schottky-Diode die Halbleiterschichten 2, 3 durch naßchemische oder trockenchemische Ätzverfahren derart entfernt, daß die Ätze an der Ätzstopschicht 4 stoppt (FIG. 3). Anschließend wird ein selektiver Ätzprozeß verwendet, der die freigelegte Ätzstopschicht 4 abträgt und an der Oberfläche der Isolierschicht 3 stoppt. Die Isolierschicht 3 wird im Bereich der PIN-Diode teilweise entfernt, so daß die n-Kontaktschicht 1 im Bereich der Kathode freiliegt. Danach werden durch z.B. Photolithographieverfahren die ohmschen Kontaktbereiche definiert und hergestellt. Mit z.B. Stepper-oder Elektronenstrahllithographieverfahren wird der Schottkykontaktbereich definiert und die Metallkontakte in einem Aufdampfverfahren realisiert (FIG. 4).

Die Erfindung ist nicht auf die angegebenen Ausführungsbeispiele beschränkt, sondern es können mehrere PIN- und Schottky-Dioden monolithisch integriert werden, je nach den im Schaltkreis zu realisierenden Mischer- und Schalterfunktionen. Weiterhin ist die Verwendung anderer III/V-Halbleiterverbindungen zur Herstellung der Halbleiterschichtenfolge möglich.

## Patentansprüche

1. Monolithisch intergrierter Schaltkreis mit dem verschiedene Mischer- und Schalterfunktionen durchgeführt werden können, wobei der Schaltkreis zumindest eine PIN-und Schottky-Diode enthält, die monolithisch integriert sind, wobei
- die PIN-Diode aus einer hochdotierten n- und p-Kontaktschicht (1, 2) und einer zwischen den Kontaktschichten (1, 2) eingebrachten, gering dotierten Isolierschicht (3) besteht, in der in einem bestimmten Abstand d von der n-Kontaktschicht (1) eine Ätzstopschicht (4) angeordnet ist,
- die Schottky-Diode lateral neben der PIN-Diode angeordnet ist und aus der gleichen hochdotierten n-Kontaktschicht (1) und der gering dotierten Isolierschicht (3) mit einer Schichtdicke d besteht,
- die Kontakte der Schottky-Diode auf der Isolierschicht (3) aufgebracht sind, und
- der Anodenkontakt der PIN-Diode auf der p-Kontaktschicht (2) und der Kathodenkontakt auf der n-Kontaktschicht (1) aufgebracht ist.

2. Monolithisch integrierter Schaltkreis nach Anspruch 1, dadurch gekennzeichnet, daß PIN- und Schottky-Diode in Mesabauweise angeordnet sind.

3. Monolithisch integrierter Schaltkreis nach Anspruch 1, dadurch gekennzeichnet, daß die PIN-Diode als Schalterelement und die Schottky-Diode als Mischerelement ausgebildet sind.

4. Monolithisch integrierter Schaltkreis nach Anspruch 3, dadurch gekennzeichnet, daß die Kontakt- und Isolierschichten (1, 2, 3) aus GaAs bestehen und auf einem GaAs-Substrat aufgebracht sind.

5. Monolithisch integrierter Schaltkreis nach Anspruch 3, dadurch gekennzeichnet, daß die p-Kontakt- und die Isolierschicht (2, 3) aus InGaAs, die n-Kontaktschicht (1) aus InGaAs bestehen und auf einem InP-Substrat aufgebracht sind.

6. Monolithisch integrierter Schaltkreis nach den Ansprüchen 4 und 5, dadurch gekennzeichnet,
- daß die n-Kontaktschicht (1) eine Schichtdicke von weniger als 1µm und einer Dotierkonzentration N_{D} größer 10¹⁸cm⁻³
- daß die p-Kontaktschicht (2) eine Schichtdicke von etwa 100nm und eine Dotierkonzentration N_{A} größer 10¹⁹cm⁻³, und
- daß die Isolierschicht (3) eine Schichtdicke von weniger als 2µm und eine Dotierkonzentration N_{D} kleiner 10¹⁷cm⁻³ aufweist.

7. Monolithisch integrierter Schaltkreis nach Anspruch 3, dadurch gekennzeichnet,
- daß die Ätzstopschicht (4) in einem Abstand d von weniger als 100nm von der n-Kontaktschicht (1) in die Isolierschicht (3) eingebracht ist, und
- daß die Schichtdicke der Ätzstopschicht (4) 2 bis 5nm beträgt.

8. Verfahren zur Herstellung einer monolithisch integrierten PIN-/Schottky-Diodenanordnung nach den vorhergehenden Ansprüchen, dadurch gekennzeichnet,
- daß auf einem Halbleitersubstrat eine n-Kontaktschicht (1), eine Isolierschicht (3), die eine Ätzstopschicht (4) enthält, und eine p-Kontaktschicht (2) epitaktisch aufgewachsen werden,
- daß die n-Kontaktschicht (2) und die Isolierschicht (3) im Bereich der Schottky-Diode entfernt werden, derart, daß die Ätze an der Ätzstopschicht gestoppt wird,
- daß die freigelegte Ätzstopschicht (4) entfernt wird,
- daß die Isolierschicht (3) im Bereich der Kathode der PIN-Diode weggeätzt wird, und
- daß anschließend die Kontakte strukturiert werden.

## Claims

1. Monolithic integrated circuit by which various mixer and switch functions can be performed, wherein the circuit comprises at least one PIN diode and Schottky diode, which are monolithically integrated, wherein
- the PIN diode consists of a highly doped n contact layer (1) and p contact layer (1, 2) and a lightly doped insulated layer (3) which is introduced between the contact layers (1, 2) and in which an etched barrier layer (4) is arranged at a specific spacing d from the n contact layer (1),
- the Schottky diode is arranged laterally adjacent to the PIN diode and consists of the same highly doped n contact layer (1) and lightly doped insulating layer (3) with a layer thickness (d),
- the contacts of the Schottky diode are applied to the insulating layer (3) and
- the anode contact of the PIN diode is applied to the p contact layer (2) and the cathode contact of the PIN diode to the n contact layer (1).

2. Monolithic integrated circuit according to claim 1, characterised in that the PIN and Schottky diodes are arranged in mesa mode of construction.

3. Monolithic integrated circuit according to claim 1, characterised in that the PIN diode is constructed as a switch element and the Schottky diode as a mixer element.

4. Monolithic integrated circuit according to claim 3, characterised in that the contact and insulating layers (1, 2, 3) consist of GaAs and are applied to a GaAs substrate.

5. Monolithic integrated circuit according to claim 3, characterised in that the p contact layer (2) and the insulating layer (3) consist of InGaAs and the n contact layer (1) of InGaAs and are applied to an lnP substrate.

6. Monolithic integrated circuit according to claims 4 and 5, characterised in that
- the n contact layer (1) has a layer thickness of less than 1 micrometre and a doping concentration N_{D} greater than 10¹⁸cm⁻³,
- the p contact layer (2) has a layer thickness of approximately 100 nanometres and a doping concentration N_{A} greater than 10¹⁹cm⁻³ and
- the insulating layer (3) has a layer thickness of less than 2 micrometres and a doping concentration N_{D} smaller than 10¹⁷cm⁻³.

7. Monolithic integrated circuit according to claim 3, characterised in that
- the etched barrier layer (4) is introduced in the insulating layer (3) at a spacing of less than 100 nanometres from the n contact layer (1) and
- the layer thickness of the etched barrier layer (4) amounts to 2 to 5 nanometres.

8. Method of producing a monolithic integrated PIN diode and Schottky diode arrangement according to the preceding claims, characterised in that
- an n contact layer (1), an insulating layer (3) containing an etched barrier layer (4), and a p contact layer (2) are epitaxially grown on a semiconductor substrate,
- the n contact layer (2) and the insulating layer (3) are removed in the region of the Schottky diode in such a manner that the etching at the etching barrier layer is blocked,
- the exposed etched barrier layer (4) is removed,
- the insulating layer (3) is etched away in the region of the cathode of the PIN diode and
- subsequently the contacts are structured.

## Revendications

1. Circuit intégré monolithique, au moyen duquel différentes fonctions de mélangeurs et de commutateurs peuvent être exécutées, le circuit contenant au moins une diode PIN et une diode Schottky, qui sont intégrées de façon monolithique, dans lequel
- la diode PIN est constituée par des couches de contact de type p et n fortement dopées (1, 2) et par une couche isolante faiblement dopée (3), qui est insérée entre les couches de contact (1, 2) et dans laquelle une couche d'arrêt de corrosion (4) est disposée à une distance déterminée d de la couche de contact (1),
- la diode Schottky est disposée latéralement à côté de la diode PIN et est constituée par la même couche de contact de type n fortement dopée (1) et la couche isolante faiblement dopée (3) possédant une épaisseur de couche d,
- les contacts de la diode Schottky sont disposés sur la couche isolante (3), et
- le contact d'anode de la diode PIN est disposé sur la couche de contact de type p (2) et le contact de cathode est disposé sur la couche de contact de type n (1).

2. Circuit intégré monolithique selon la revendication 1, caractérisé en ce que la diode PIN et la diode Schottky sont disposées selon une forme de réalisation mesa.

3. Circuit intégré monolithique selon la revendication 1, caractérisé en ce que la diode PIN est agencée sous la forme d'un élément formant commutateur et que la diode Schottky est agencée sous la forme d'un élément formant mélangeur.

4. Circuit intégré monolithique selon la revendication 3, caractérisé en ce que les couches de contact et la couche isolante (1, 2, 3) sont constituées de GaAs et sont disposées sur un substrat GaAs.

5. Circuit intégré monolithique selon la revendication 3, caractérisé en ce que la couche de contact de type p et la couche isolante (2, 3) sont formées de InGaAs, que la couche de contact de type n (1) est formée de InGaAs et que ces couches sont disposées sur un substrat en InP.

6. Circuit intégré monolithique selon les revendications 4 et 5, caractérisé en ce
- que la couche de contact de type n (1) possède une épaisseur de couche inférieure à 1 µm et une concentration de dopage N_{D} supérieure à 10¹⁸ cm⁻³,
- que la couche de contact de type p (2) possède une épaisseur de couche d'environ 100 nm et une concentration de dopage N_{A} supérieure à 10¹⁹ cm ⁻³, et
- que la couche isolante (3) possède une épaisseur de couche inférieure à 2 µm et une concentration de dopage N_{D} inférieure à 10¹⁷ cm⁻³.

7. Circuit intégré monolithique selon la revendication 3, caractérisé en ce
- que la couche d'arrêt de corrosion (4) est insérée dans la couche isolante (3) à une distance d, inférieure à 100 nm, de la couche de contact de type n (1), et
- que l'épaisseur de la couche d'arrêt de corrosion (4) est comprise entre 2 et 5 nm.

8. Procédé pour fabriquer un dispositif intégré monolithique à diodes PIN / Schottky selon les revendications précédentes, caractérisé en ce
- qu'on fait croître par épitaxie, sur un substrat semiconducteur, une couche de contact de type n (1), une couche isolante (3), qui contient une couche d'arrêt de corrosion (4), et une couche de contact de type p (2),
- qu'on élimine la couche de contact de type p (2) et la couche isolante (3) dans la zone de la diode Schottky de telle sorte que la corrosion est arrêtée au niveau de la couche d'arrêt de corrosion,
- qu'on élimine la couche d'arrêt de corrosion (4) mise à nu ;
- qu'on élimine par corrosion la couche isolante (3) dans la zone de la cathode de la diode PIN, et
- qu'on structure ensuite les contacts.
